Europäisches Patentamt

European Patent Office

Office européen des brevets

(19)

(11) **EP 1 624 576 A1**

(12) **EUROPEAN PATENT APPLICATION**

(43) Date of publication:
**08.02.2006 Bulletin 2006/06**

(51) Int Cl.:
**H03L 7/185** *(2006.01)*          **H03L 7/23** *(2006.01)*

(21) Application number: **04018296.6**

(22) Date of filing: **02.08.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(71) Applicant: **Digital Multimedia Technologies S.P.A.
20035 Lissone (MI) (IT)**

(72) Inventor: **Rivolta, Daniele
20035 Lissone (MI) (IT)**

(74) Representative: **Grünecker, Kinkeldey,
Stockmair & Schwanhäusser
Anwaltssozietät
Maximilianstrasse 58
80538 München (DE)**

(54) **A PLL based frequency synthesizer having a frequency mixer in the feedback branch**

(57)     RF signals in a specified range, such as the UHF band, may be created in a highly flexible fashion at reduced levels of phase noise in that a frequency-shifting is performed within the feedback branch of a PLL circuit. Preferably, the output signal of a VCO is shifted in frequency twice by corresponding mixer stages, which may be operated on the basis of a common intermediate signal.

Fig.2a

EP 1 624 576 A1

**Description**

Field of the Present Invention

The present invention relates to synthesizing of Rf (radio frequency) signals within a specified frequency band, such as the UHF band, wherein a plurality of channels are defined having slightly different frequencies that may then be used to convey channel-specific information. The carrier waves of the different channels are formed on the basis of a single high quality reference signal by using a controllable oscillator, such as a voltage-controlled oscillator (VCO), which is controlled by a phase locked loop (PLL) circuit.

Description of the Related Art

In wireless data communication systems, there is an ongoing drive to enhance device performance while at the same time reduce production costs. One critical aspect in achieving high performance is the generation of high quality carrier signals with specified frequency steps within a desired frequency band. A high quality carrier signal is required in view of selectivity and range, and thus in view of data integrity. The finally achieved error rate in transmitting information via an Rf carrier signal, however, strongly depends on the quality of the oscillator for generating the carrier wave. As is well known, every electronic device generates a certain amount of noise during operation and therefore also any oscillator produces a non-ideal output signal and is therefore subjected to the so-called phase noise. The phenomenon of phase noise is implicit to all oscillators and occurs when an oscillator does not maintain the desired frequency for a short time period. As previously mentioned, each transmitter or receiver device used in the wireless data communication requires an oscillator, and hence the phase noise is an inherent phenomenon of any wireless data communication system, thereby producing a plurality of negative effects, such as modulation errors, high bit error rates, and blocking of neighbor channels, wherein the degree of each of these errors and effects significantly depends on the amount of phase noise produced by the oscillator that provides the Rf carrier signals of the various communication channels.

Several methods are known for generating or synthesizing signals at variable, closely spaced frequencies, as are required for the discrete communication channels. Essentially, these methods are based on the employment of frequency mixers, frequency dividers, and frequency multipliers.

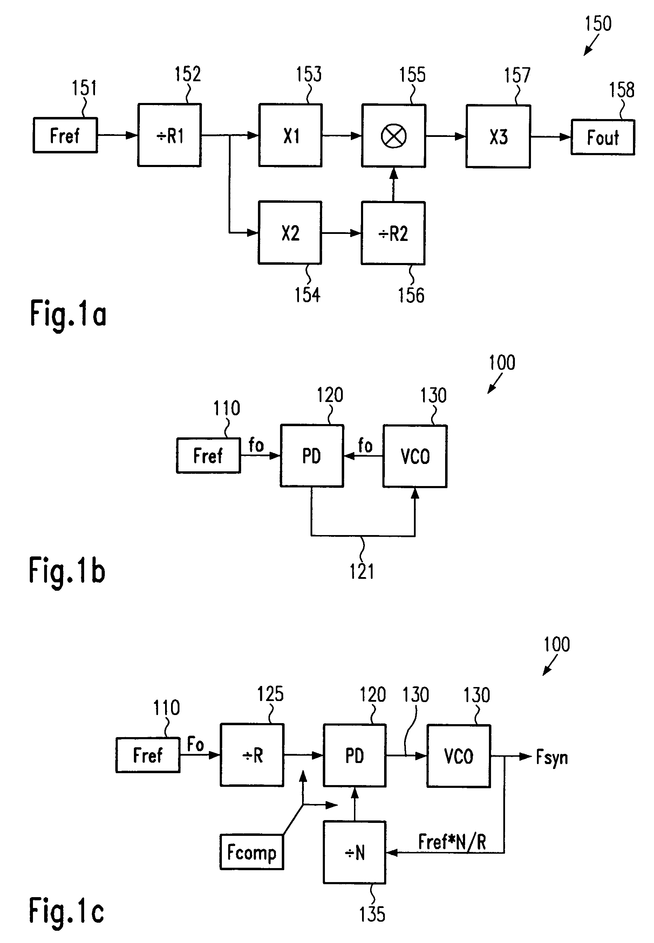

Fig. 1 a schematically shows a block diagram of a frequency synthesizer 150 that is configured to generate an output signal $f_{out}$ 158 having a desired frequency from a high quality reference signal $f_{ref}$ 151, wherein a plurality of frequency multipliers 153, 154 and 157 are used in combination with frequency dividers 152 and 156, wherein the signals obtained by the branches defined by the elements 152, 153 on the one hand, and defined by the elements 152, 154, and 156 on the other hand are supplied to a mixer 155 that is configured to provide signals having a frequency corresponding to the difference and the sum of the input signals supplied thereto. However, owing to a combination of a plurality of frequency dividers and multipliers, the system 150 is quite complex and is less flexible in obtaining moderately closely spaced output frequencies.

Another approach in generating or synthesizing a plurality of Rf signals having different frequencies on the basis of a single high quality reference signal is the employment of controllable oscillators, such as voltage controlled oscillators, which are controlled by a phase detector that compares the phase of the reference signal and the signal output by the controllable oscillator.

Fig. 1 b schematically shows a corresponding concept of a frequency synthesizer 100 comprising a controllable oscillator that is controlled on the basis of a single reference signal. The frequency synthesizer 100 includes a reference signal source 110, which may be provided in the form of a quartz oscillator generating a high quality signal with frequency $f_0$, which is supplied to a first input of a phase detector 120, a second input of which is connected to a controllable oscillator 130 provided in the form of a voltage controlled oscillator. The phase detector 120 may be configured so as to generate and provide a voltage 121 corresponding to a specified function that is defined by the gain of the phase detector 120 and the phase difference of the signals provided by the reference source 110 and the controllable oscillator 130. Hence, the phase detector 120 "locks" into the frequency $f_0$ of the reference source 110 such that the controllable oscillator 130 generates a substantially phase coherent output signal of the same frequency. Hereby, the phase noise of the signal output by the controllable oscillator 130 depends on the noise created by the phase detector 120 and the controllable oscillator 130, and also depends on the initial phase noise of the reference source, which, however, is considered a high quality source, so that the finally obtained phase noise is substantially determined by the phase detector 120 and the controllable oscillator 130.

Fig. 1 c schematically shows the frequency synthesizer 100 with a frequency divider network so as to be able to produce signals at frequencies other than the frequency $f_0$ of the reference source 110. A first frequency divider 125, also indicated as R, is connected between the references source 110 and a first input of the phase detector 120, while a second frequency divider 135, also indicated as N, is connected between the output of the controllable oscillator 130 and the second input of the phase detector 120. Thus, the output frequency $f_{syn}$ of the controllable oscillator 130 is given

by $f_{syn} = f_0 \cdot N/R$.

The frequency synthesizer 100 shown in Fig. 1 c is more flexible and less complicated in structure compared to the synthesizer 150 shown in Fig. 1a, wherein additionally based on modern semiconductor technologies the functions of frequency dividers may readily be combined with the circuitry of the phase detector 120 so that phase locked loop (PLL) integrated circuits are now available that allow to receive input signals with a frequency up to approximately 6 GHz, with the capability to compare signals over a frequency range up to approximately 50 MHz.

From the structure of the synthesizer 100 as shown in Fig. 1 c it is evident that for a tunable divider 135 the minimum shift of the adjacent output frequencies $\Delta f_{syn}$ is determined by the reference frequency $f_0$, the divider 125, and the minimal step width $\Delta N$ of the divider 135, which is assumed to be equal to 1. Thus, the channel spacing, that is, $\Delta f_{syn}$, may be expressed by:

$$(1) \qquad \Delta f_{syn} = f_0/R \cdot \Delta N; \quad \Delta N = 1$$

Hence, the compare frequency $f_{comp}$, at which the phase detector 120 is operated, is then given by equation 2.

$$(2) \qquad \Delta f_{syn} = f_0/R \rightarrow f_{comp}$$

Consequently, for a desired step width in frequency of the output signal of $f_{syn}$ and for a desired bandwidth, i.e., for a desired maximum and minimum output frequency $f_{syn}$, the values for the dividers 125 and 135 are determined by formulas 1 and 2. However, the selection of the values for the dividers 125 and 135 may significantly affect the phase noise of the output signal $f_{syn}$ for the following reason. The synthesizer 100 as shown in Fig. 1c substantially represents an amplifier for the phase noise created in the output signal $f_{syn}$. The phase noise within the loop band width is approximately given by

$$(3) \qquad L_{VCO} \cong L_{PD} + 10\log(f_{comp}) + 20\log(N) + \{L_{Ref} - 20\log(R)\};$$

$$N = f_{syn}/f_{comp}$$

$$\rightarrow L_{VCO} \cong L_{PD} + 10\log(f_{syn}/f_{comp}) + \{L_{Ref} - 20\log(R)\} =$$

$$= L_{PD} + 20\log(f_{sync}) - 10\log(f_{comp}) + \{L_{Ref} - 20\log(R)\}$$

wherein $L_{vco}$ represents the phase noise generated at the output of the controllable oscillator 130, $L_{PD}$ represents the phase noise created in the phase detector 120, and $L_{Ref}$ represents the phase noise of the reference source 110. As is evident from equation 3, for a given comparison frequency $f_{comp}$, at which the phase detector 120 operates and which defines the frequency step width within the frequency band of interest (cf. equation 2), the total phase noise strongly depends on the maximum output frequency $f_{syn}$, thereby making a desired selection of the maximum frequency difficult, since the increased phase noise may not be maintained within acceptable ranges with respect to data corruption, selectivity, transmission range, and the like. For example, with a maximum output frequency $f_{syn}$ of 1338 MHz, and for an operating frequency of the phase detector 120, $f_{comp}$ of 1 MHz, an increase of 62.5 dB of the phase noise is created in the phase detector 120.

In an attempt to maintain the values of the feedback divider 135 at low levels (cf. equation 3) PLL circuits have been proposed that include fractional dividers. However, these fractional dividers generate several spurious signals, which, in turn, require specific countermeasures so as to maintain the spurious signals as low as possible. A corresponding circuitry for reducing the effect of these spurious signals may be configured to produce white noise instead of having localized interference signals. Based on this concept, a moderate increase of approximately 12dB for the background phase noise may be obtained in the phase detector 120. In any case, increasing the operating frequency $f_{comp}$ of the phase detector 120 may be less desirable, since the expected reduction of the phase noise is counteracted by the factor $10\log(f_{comp})$: $f_{comp}$ must increase because $f_{syn}$ has the same value. The term $10\log(f_{comp})$ takes into account the increased switching frequency during operation of the digital phase detector that approaches the time uncertainty jitter of the devices. Increasing $f_{comp}$ implies the increasing in any shifting steps of $f_{syn}$ (distance from channels) thereby making this not acceptable with respect to the system point of view.

In view of the problems identified above, it is therefore an object of the present invention to provide a frequency synthesizer that enables to maintain the phase noise at a low level while simultaneously providing an increased flexibility in selecting a bandwidth and a channel distance with a circuit design of moderately low complexity.

Summary of the Invention

Generally, the present invention is based on the concept that a frequency synthesizer on the basis of a phase detector may be used in view of reduced circuit complexity and increased operational flexibility, wherein the phase noise obtained in the output signal may be reduced compared to conventional frequency synthesizers in that a frequency shifting or translating means is incorporated within the feedback branch of the phase detector, thereby enabling to maintain the value of a corresponding frequency divider at an input of the PLL circuit at a low level while still providing for a reduced operating frequency for the phase detector. In this way, there exists a high flexibility in selecting the distance in frequency between adjacent carrier signals while still providing for a desired large bandwidth without unduly increasing the phase noise of the output signals.

According to one aspect of the present invention, a frequency synthesizer for a wireless communication device comprises a phase detector having a first input, a second input, and a control output, wherein the phase detecor is configured to provide a control signal at the control output that is indicative of a phase difference of a first signal received at the first input and a reference signal received at the second input. The frequency synthesizer further comprises a controllable oscillator having an input coupled to the control output and also having an output. Moreover, a feedback branch is provided and connected between the output of the controllable oscillator and the first input of the phase detector, wherein the feedback branch includes a frequency mixer configured to receive a shifting signal from a second reference source and a signal from the output of the controllable oscillator.

By providing the frequency mixer within the feedback branch connecting the contollable oscillator and one input of the phase detector, an output signal of the controllable oscillator may be mixed with the shifting signal of the second reference source, thereby providing at least one substantially phase coherent signal having a reduced frequency compared to the output signal of the controllable oscillator. Consequently, the phase detector may be operated with a significantly lowered value for the frequency divider compared to a conventional device when operated with a comparable operating frequency for the phase detector. Consequently, the phase noise may be reduced while maintaining a desired broad bandwidth with frequency steps between adjacent channels that may be selected in a more flexible fashion while still enhancing data integrity

In a further preferred embodiment, the frequency mixer comprises a first mixer stage and a second mixer stage, wherein the first and second mixer stages are coupled to each other in cascade.

By means of the first and second mixer stages, the portion of the output frequency obtained from the controllable oscillator may be more efficiently shifted or translated to a lower value, thereby offering the possibility of further reducing the frequency divider and hence lowering the phase noise.

In another preferred embodiment, the first and second mixer stages are connected so as to receive the shifting signal. Hence, both the first and the second mixer stage may be operated with the same shifting signal, thereby simplifying the structure of the frequency synthesizer. Moreover, by using a single shifting signal for both the first and second mixer stage, a doubled effect in translating the output frequency of the controllable oscillator is achieved, while introducing only "a single" amount of phase noise introduced by the shifting signal.

In a further embodiment, the frequency synthesizer further comprises a translation frequency synthesizer for generating the shifting signal. Thus, a well-established circuitry may be used in providing the shifting signal without undue design complexity.

In another embodiment, the translation frequency synthesizer comprises a second phase detector, a second controllable oscillator, and a second feedback branch connected between the second controllable oscillator and the second phase detector. Hence, in principle a similar construction may be used for generating the shifting signal, as is also employed for generating the actual output signal of the frequency synthesizer. Accordingly, well-established semiconductor components may be used, thereby making the frequency synthesizer extremely cost efficient.

In a further preferred embodiment, the second feedback branch comprises a second frequency mixer. Hence, in synthesizing the shifting signal, the concept of translating or shifting the output signal of the corresponding controllable oscillator may also be used so as to provide for an increased flexibility and reduced phase noise in generating the shifting signal.

In a further preferred embodiment, the second frequency mixer is connected so as to receive a second intermediate signal that is derived from the reference signal. Hence, a high degree of design flexibility is achieved while a single high quality reference signal source is sufficient to provide for the actual output signal and the shifting signal.

In another preferred embodiment, the second phase detector is connected so as to receive the reference signal or a phase coherent derivative thereof. Consequently, the second phase detector used in generating the shifting signal may also be operated on the basis of the reference signal, thereby providing for reduced phase noise, enhanced flexibility, and reduced circuit complexity. In another embodiment, the frequency synthesizer further comprises a frequency divider means that generates the phase coherence derivative of the reference signal, wherein the frequency divider means is configured to maintain the phase coherent derivative in an integer numerical relation with respect to the reference signal. Hence, simple and readily available circuitry may be used for the frequency divider means, thereby maintaining the phase noise at a low level while providing for reduced production costs.

In a further embodiment, the frequency synthesizer comprises filter means in the feedback branch. In one embodiment, the filter means comprises a first filter unit connected between the first filter stage, which is arranged as a front end stage, and the second filter stage, which is arranged as a back end stage. Moreover, the filter means comprises a second filter unit connected between the second filter stage and the phase detector.

By means of the filter means, any unwanted frequency portions in the feedback branch may effectively be filtered so that the phase detector may be operated on the basis of a feedback signal substantially lacking any unwanted signal portions. For instance, the first filter unit may be designed as a band pass filter removing the upper mixed frequency portion, and removing any lower interference portions, wherein a relatively wide band pass range may be sufficient to effectively remove any unwanted signal portion, since the desired down converted frequency is spaced moderately far apart from the upper mixed frequency component. The second filter unit may then be designed as a low pass filter so as to reliably transmit the frequency component, which has now been frequency-shifted twice by the first and second mixer stages, wherein the higher mixed frequency component is then reliably removed by the low pass filter.

In a further preferred embodiment, a loop filter is provided between the phase detector and the controllable oscillator.

The loop filter may be designed for high performance of the phase detector with respect to settling time and amplifier gain, wherein contrary to conventional loop filters in PLL circuits operated with a direct feedback, the operating frequency of the phase detector may be selected moderately high for efficiently filtering spurious lines in the reference signal, while nevertheless maintaining low phase noise of the phase detector due to the low value of the frequency divider.

In accordance with another aspect of the present invention, a method of operating a frequency synthesizer comprises controlling a phase and a frequency of an output signal of the frequency synthesizer by:

frequency-shifting a feedback portion of the output signal in a phase coherent fashion and comparing the phase of a reference signal or a phase coherent derivative thereof with the phase coherent and frequency shifted feedback portion obtained from the output signal. The method further comprises adjusting a frequency and a phase of the output signal on the basis of a result of the comparison.

Applying the above method for operating a frequency synthesizer provides substantially the same advantages as are already pointed out above with reference to the embodiments relating to the synthesizer device. Consequently, a desired wide bandwidth combined with moderately closely spaced individual frequency channels may be accomplished by the method described above, wherein the phase noise is significantly reduced.

In one preferred embodiment, the frequency-shifting of the feedback portion comprises the frequency-shifting of the feedback portion at twice. Hence, the frequency of the signal finally used in the comparison with the reference signal may efficiently be lowered by "cascading" at least two frequency-shift operations.

In a further preferred embodiment, the frequency shifting of the feedback portion includes mixing the output signal with a first translating or shifting signal to obtain a first feedback signal. By generating the first feedback signal by mixing the output signal with a first shifting signal, any unwanted signal portions may effectively be filtered out without unduly influencing the process of comparing the frequency-shifted feedback portion with the reference signal or phase coherent derivative.

Similarly, the first feedback signal may be mixed with a second shifting signal to obtain a second feedback signal that may then be used for the comparison with the reference signal or the phase coherent derivative.

Preferably, the first and the second shifting signals are identical, thereby adding a moderately low phase noise to the total phase noise of the finally obtained output signal.

Further advantageous embodiments of the present invention are also defined in the appended claims and any advantages obtained therefrom may become apparent from the following detailed description, when taken in conjunction with the accompanying drawings, in which:

Fig. 1a schematically shows a conventional frequency synthesizer including a plurality of frequency dividers and multipliers;

Figs. 1b and 1c schematically show a frequency synthesizer based on a controllable oscillator, which is controlled by a phase detector;

Figs. 2a and 2b schematically show a frequency synthesizer in accordance with illustrative embodiments of the present invention; and

Figs. 3a and 3b depict graphs representing the calculated phase noise of a frequency synthesizer in accordance with the present invention (Fig. 3a), and according to a conventional design (Fig. 3b), respectively.

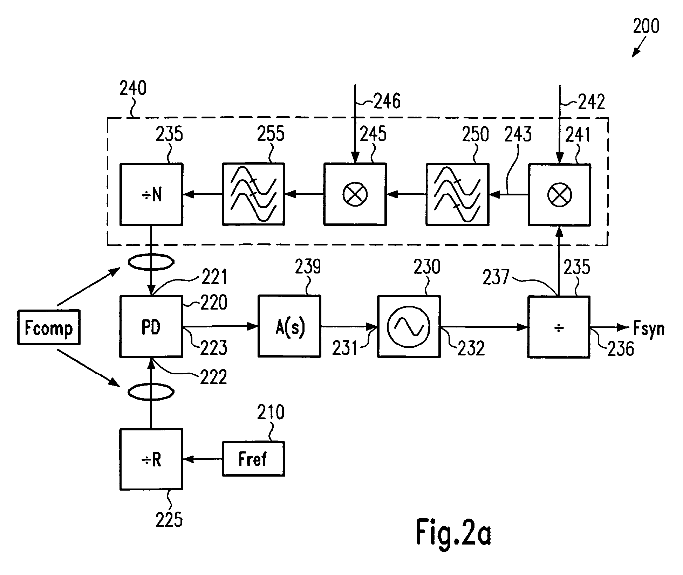

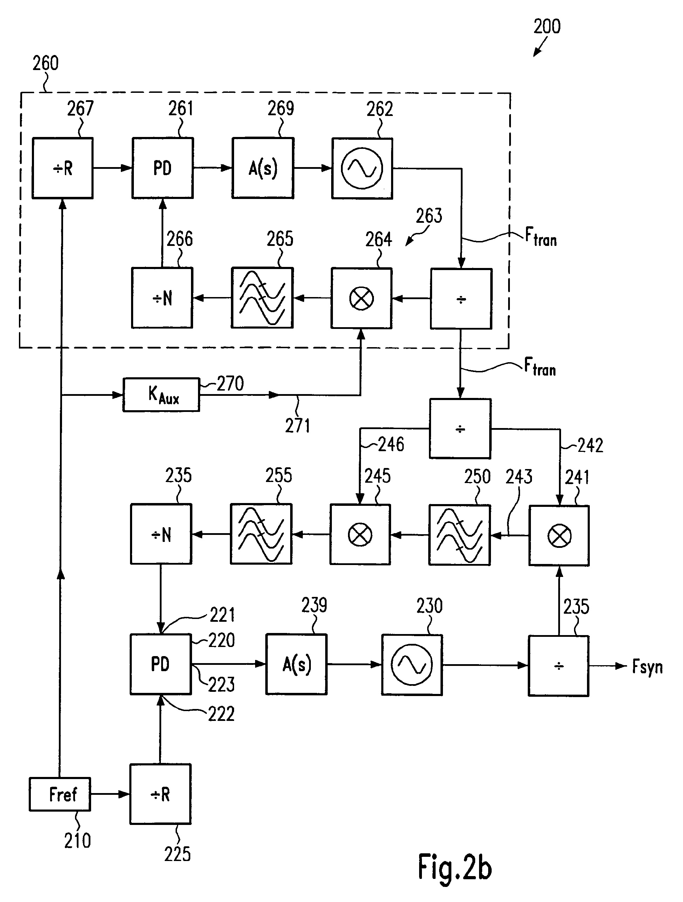

With reference to Figs. 2a, 2b, and 3a, further preferred embodiments of the present invention will now be described in more detail.

Fig. 2a schematically shows a frequency synthesizer 200 that comprises a phase detector 220 having a first input 221 and a second input 222. The phase detector 220 also comprises a control output 223 that is connected to a control input 231 of a controllable oscillator 230 via a loop filter 239. An output 232 of the controllable oscillator 230 is connected to an output device 235 that provides on a first output 236 the output signal $F_{syn}$, which may be used by further circuitry of a data communication device (not shown). A second output 237 is connected to feedback branch 240, which includes at least one frequency mixer 241 configured to receive a first translating or shifting signal 242 and to provide corresponding frequency-shifted first shifting signals 243. In one preferred embodiment as shown in Fig. 2a, the feedback branch 240 may further comprise a second mixer stage 245 connected with one input to a filter unit 250 and having a second input to receive a second shifting signal 246, wherein in advantageous embodiment, the first shifting signal 242 and the second shifting signal 246 are substantially identical and may be delivered by the same signal source, as will be described in more detail with reference to Fig. 2b. An output of the second mixer stage 245 is connected to a second filter unit 255, which in turn is connected to a frequency divider 235, which may be provided in the form of a discrete frequency divider, or which may be incorporated in the phase detector 220. Hence, in the embodiment shown, the feedback branch 240 comprises the first mixer stage 241 arranged as an upstream mixer stage, followed by the mixer stage 245, which represents the downstream mixer stage. In other embodiments, a single frequency mixer may be provided in the feedback branch 240 or more than two mixer stages may be arranged in cascade in the feedback branch 240.

The synthesizer 200 further comprises a second frequency divider 225, which is connected with its output to the input 222, and which is connected with its input to a reference signal source 210 that may supply a high quality reference signal, which, for convenience, will also be denoted by 210. For instance, the reference signal 210 may be generated by a highly stable quartz oscillator.

During the operation of the synthesizer 200, the controllable oscillator 230, which may be provided in the form of a voltage controlled oscillator, provides the output signal $f_{syn}$ at the output 232, and thus at the output 236, wherein, after a certain settling time of the oscillator 230, the feedback branch 240, and the phase detector 220, the output frequency $f_{syn}$ is finally determined by the frequency of the signal received at the inputs 221 and 222 of the phase detector 220. That is, the phase detector 220 is configured to provide a corresponding control signal to the controllable oscillator 230 such that the phase and frequency of the signals provided at the input 221 and 222 are substantially equal to each other. This frequency is hereinafter referred to as $f_{comp}$ and denotes the comparison frequency at which the phase detector 220 operates. As previously explained, in view of a corruption of the phase noise background of the phase detector 220, the frequency $f_{comp}$ is to be preferably maintained at a low value. Moreover, as explained with reference to equation 3, the phase noise in the signal provided by the phase detector 220 strongly depends on the value of the frequency divider 235, which may, according to the present invention, be efficiently reduced since the divider 235 receives the second feedback signal from the filter unit 255 having a significantly reduced frequency compared to the actual output frequency $f_{syn}$ due to the provision of the first and second mixer stages 241 and 245. The first mixer stage 241 receiving the output signal $f_{syn}$ from the output 237 generates two feedback signals 243 representing the sum and the difference between the first intermediate signal 242 and the output signal $f_{syn}$, respectively. These first feedback signals 243 are conveyed to the first filter unit 250, which may be configured as a band pass filter with a band pass range selected so as to transmit the lower one of the two first feedback signals 243, wherein a corresponding filter design may be readily accomplished, since typically the first intermediate signal 242 is significantly different in frequency from the output signal $f_{syn}$. Thus, the higher frequency component may be easily filtered out, while at the same time interference signals below the band pass range may also be effectively removed. Hence, the first feedback signal, now comprising a single frequency component, is received at the second mixer stage 245, which then generates a second feedback signal representing the sum and the difference of the first feedback signal and the second shifting signal 246. The second filter unit 255 receiving the second feedback signal may then efficiently remove the higher frequency component, thereby generating the second feedback signal having the desired low frequency component, which is then delivered to the divider 235, which may thus have a significantly lower value compared to a conventional device without the feedback branch 240 and producing substantially the same comparison frequency $f_{comp}$ at the first input 221, and thus at the second input 222. Consequently, the frequency of the signals supplied to the phase detector 220 and the value of the divider 235 may be kept at a low value, thereby providing enhanced performance of the phase detector 220 in terms of phase margin, settling time, and overall phase noise.

As previously described with reference to equation 3, the total phase noise of the output $f_{syn}$ also depends on the phase noise created in the reference signal source 210 and may also depend on the phase noise of the first shifting signal 242 and the second shifting signal 246. It is therefore advantageous to provide the first and second shifting signals 242, 246 as high quality signals having a low level of phase noise. Preferably, the first and second intermediate signals 242, 246 may be provided from the same signal source, thereby introducing the phase noise of a single signal, while still obtaining the advantage of a doubly shifted feedback signal provided to the divider 235. That is, although the initial output signal $f_{syn}$ is shifted twice in frequency, only the phase noise of a single shifting signal is introduced.

For example, the frequency synthesizer shown in Fig. 2a may be configured so as to be operated up to a frequency of 1338 MHz with a step width between adjacent frequency channels of 6, 7, or 8 MHz. Moreover, the total phase noise of the corresponding output signal $f_{syn}$ at a distance from the respective carrier frequency of 100 Hz is approximately -92 dBc/Hz.

Fig. 2b schematically shows the frequency synthesizer 200 according to another preferred embodiment, which now comprises a second frequency synthesizer or translation frequency synthesizer 260 that is configured to provide the first and second shifting signals on the basis of the reference signal 210. For this purpose, the translation frequency synthesizer 260 comprises a second phase detector 261 connected to a second controllable oscillator 262 via a second loop filter 269. The second controllable oscillator is connected with its output to one input of the second phase detector 261 via a second feedback branch 263. The second feedback branch 263 may comprise a mixer stage 264 arranged to receive an auxiliary signal 271 and an output signal $f_{tran}$ from the second oscillator 262. The auxiliary signal 271 may be provided by a frequency converter means 270, which may receive the reference signal 210 and form therefrom the phase coherent auxiliary signal 271. The second feedback branch 263 may further comprise a loop filter 265, for instance provided in the form of a low pass filter, the output of which is connected to a corresponding frequency divider 266 coupled to the second phase detector 261. Moreover, a further frequency divider 267 is arranged to receive at its input the reference signal 210 and provide a frequency-divided signal to the phase detector 261.

During operation of the frequency synthesizer 200 as shown in Fig. 2b, the output signal $f_{tran}$ is generated by the translation frequency synthesizer 260 in a stable fashion after a certain settling time has elapsed. The function of the translation synthesizer is quite similar to the operation as described with reference to Fig. 2a, with the exception that a single mixer stage is provided in the form of the mixer 264 within the second feedback branch 263. In particular, the frequency shift provided by the mixer stage 264 during the feedback of the output signal of the oscillator 262 also allows enhanced flexibility and reduced phase noise levels, as is previously explained with reference to the synthesizer 200 in Fig. 2a. Moreover, due to the frequency converter means 270, the auxiliary signal 271 for operating the mixer stage 264 as well as the divided reference signal applied to the second phase detector 261 are obtained from the high quality reference signal 210, and thus the total phase noise in the output signal $f_{tran}$ is maintained at a low level, while the design of the feedback branch 263 still enables a high degree of flexibility in obtaining different output frequencies $f_{tran}$ within a relatively wide frequency range.

In one preferred embodiment, the frequency converter means 270 is configured such that the auxiliary signal 271 is kept in a predefined integer numerical relationship with respect to the reference signal 210. The output frequency $f_{tran}$, having a moderately low phase noise level due to the possibility of maintaining the value of the divider 266 at a low value while still also maintaining the frequency of the signal supplied by the divider 266 to the second phase detector 261 at a low value, is then used as the first and second shifting signals 242, 246 to operate the first and second mixer stages 241, 245, thereby introducing only a moderately low level of additional phase noise.

For example, the frequency synthesizer 200 as shown in Fig. 2b may create a phase noise of approximately -100 dBc/Hz for a value of the divider 235 of 27 at a frequency of 1338 MHz at distance of 100 Hz with respect to the carrier frequency. Contrary thereto, a conventional device operated by directly synthesizing the frequency of 1338 MHz without an additional frequency shift in the feedback branch generates a phase noise of approximately -78 dBc/Hz, thereby clearly demonstrating the significant improvement obtained by the present invention.

Fig. 3a schematically shows a graph representing the results of a calculation based on the frequency synthesizer as shown in Fig. 2b, wherein curve B represents the total phase noise of the output signal $f_{syn}$, curve A represents the total phase noise created in the phase detector 220, and curve C represents the phase noise created by the controllable oscillator 230. The horizontal axis represents the offset from the respective carrier, wherein the calculation is based on the assumption that the value of the divider 235 is 27, and the reference frequency is 28 MHz, so that a comparison frequency $f_{comp}$ for the phase detecor 220 of 4 MHz is obtained at a maximum frequency $f_{syn}$ of 1338 MHz.

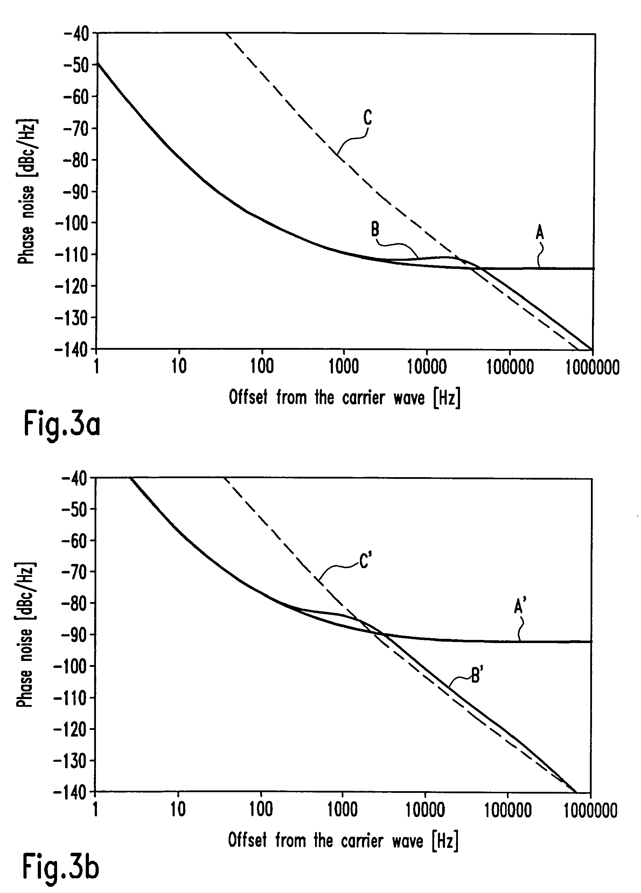

Fig. 3b schematically represents the corresponding calculation results for a conventional frequency synthesizer, i.e., for a frequency synthesizer with a feedback branch without any frequency shift prior to the corresponding divider at the phase detector. In order to obtain the same comparison frequency $f_{comp}$ of 4 MHz with the same reference frequency of 28 MHz, the divider value is set to 334. Thus, the curve A', representing the total phase noise of the conventional phase detector is significantly enhanced compared to the curve A, owing to the significantly increased value of the frequency divider. Consequently, since the phase noise created by the controllable oscillator of the conventional device, represented by the curve C', is identical to the curve C, the total phase noise represented by B' is also significantly higher compared to curve B of Fig. 3a, thereby clearly demonstrating the advantages of the present invention compared to a conventional frequency synthesizer.

As a result, the present invention allows a highly flexible adjustment of carrier frequencies within a desired wide frequency band, such as the UHF band used for DVB, wherein the reduced level of phase noise produces intermediate frequency signals in demodulating or modulating the carrier signals that may comply with the respective modulation mask substantially without cutting off portions of the small signal range. The creation of variable RF signals with a low level of phase noise may be achieved with enhanced flexibility compared to conventional designs and may not require an external excess to the frequency synthesizer. Moreover, integrated circuits may be used that are readily available on the market, thereby reducing production costs and simplifying the configuration of the inventive frequency synthesizer.

**Claims**

1. A frequency synthesizer for a wireless communication device, comprising:

   a phase detector (220) having a first input (221), a second input (222) and a control output (223), said phase detector (220) being configured to provide a control signal at the control output (223) that is indicative of a phase difference of a first signal received at the first input (221) and a reference signal received at the second input (222), a controllable oscillator (230) having an input (231) coupled to said control output (223) and having an output (232),
   a feedback branch (240) connected between said output (232) of the controllable oscillator (230) and said first input (221) of the phase detector (220), said feedback branch (240) including a frequency mixer (241, 245) configured to receive a shifting signal (242, 246) from a second reference source (260) and a signal from said output (232) of the controllable oscillator (230).

2. The frequency synthesizer of claim 1, wherein said frequency mixer (241, 245) comprises a first mixer stage (241) and a second mixer stage (245), the first and second mixer stages coupled to each other in cascade.

3. The frequency synthesizer of claim 2, wherein said first and second mixer stages are connected to receive said shifting signal.

4. The frequency synthesizer of any of claims 1 to 3, further comprising a translation frequency synthesizer (260) for generating said shifting signal.

5. The frequency synthesizer of claim 4, wherein said translation frequency synthesizer (260) comprises a second phase detector (261), a second controllable oscillator (262) and a second feedback branch (263) connected to said second controllable oscillator (262) and said second phase detector (261).

6. The frequency synthesizer of claim 5, wherein said second feedback branch comprises a second frequency mixer (264).

7. The frequency synthesizer of claim 6, wherein said second frequency mixer is connected to receive a second shifting signal derived from said reference signal.

8. The frequency synthesizer of any of claims 5 to 7, wherein said second phase detector is connected to receive said reference signal or a phase coherent derivative thereof.

9. The frequency synthesizer of claim 8, further comprising a frequency converter means (270) that generates said phase coherent derivative of said reference signal, said frequency converter means (270) being configured to maintain said phase coherent derivative in an integer numerical relation with respect to said reference signal.

10. The frequency synthesizer of any of claims 1 to 9, further comprising a loop filter means (239) connected between said phase detector (220) and said controllable oscillator (230).

11. The frequency synthesizer of claim 2, further comprising filter means comprising
    a first filter unit (250) connected between said first mixer stage (241), arranged as an upstream stage, and said second mixer stage (245), arranged as a front end stage, and
    a second filter unit (255) connected between said second mixer stage (245) and said phase detector (220).

12. A method of operating a frequency synthesizer, the method comprising:

controlling a phase and a frequency of an output signal of the frequency synthesizer by:

frequency shifting a feedback portion of said output signal in a phase coherent manner,
comparing the phase of a reference signal or a phase coherent derivative thereof with the phase coherent and frequency shifted feedback portion obtained from said output signal, and
adjusting a frequency and phase of said output signal on the basis of a result of said comparison.

13. The method of claim 12, wherein frequency-shifting said feedback portion comprises frequency-shifting said feedback portion at least twice.

14. The method of claim 12 or 13, wherein frequency-shifting said feedback portion includes mixing said output signal with a first shifting signal to obtain a first feedback signal.

15. The method of claim 14 and claim 13, further comprising mixing said first feedback signal with a second shifting signal to obtain a second feedback signal.

16. The method of claim 15, wherein said first and second shifting signals are identical.

17. The method of any of claims 12 to 16, further comprising generating said first and second shifting signals on the basis of said reference signal.

18. The method of claim 17, wherein said first and second shifting signals are generated by controlling a second controllable oscillator on the basis of a difference in phase of a phase coherent portion of said reference signal and a portion of the first or second shifting signals that is fed back.

19. The method of claim 18, wherein feeding back said phase coherent portion of the first or second intermediate signals comprises frequency-shifting said phase coherent portion.

20. The method of claim 19, wherein frequency-shifting said phase coherent portion includes mixing said portion fed back with an auxiliary signal derived from said reference signal.

21. The method of claim 20, wherein said auxiliary signal is provided with a specified integer numerical relation to said reference signal.

22. The method of any of claims 12 to 21, further comprising performing a frequency division on said feedback portion of the output signal prior to comparing said feedback portion with said reference signal or phase coherent portion derivated therefrom.

23. The method of claim 22, wherein a dividing factor in performing said frequency division is selected to 30 or less.

150

151                                 152              153              155              157              158

Fref → ÷R1 → X1 → ⊗ → X3 → Fout

154              156

X2 → ÷R2

# Fig.1a

100

110              120              130

Fref —fo→ PD ←fo— VCO

121

# Fig.1b

100

110              125              120   130   130

Fref —Fo→ ÷R → PD → VCO → Fsyn

Fcomp              ÷N ← Fref*N/R

135

# Fig.1c

Fig.2a

Fig.2b

Fig.3a

Fig.3b

European Patent
Office

**EUROPEAN SEARCH REPORT**

Application Number

EP 04 01 8296

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 417 703 B1 (BRADLEY DONALD A) 9 July 2002 (2002-07-09) | 1-5, 9-18,21 | H03L7/185 H03L7/23 |
| Y | * column 10, line 7 - column 11, line 45; figure 6 * | 6,7,19, 20,22,23 | |
| X | US 5 128 633 A (MARTIN FREDERICK L ET AL) 7 July 1992 (1992-07-07) | 1,4-8, 10,12, 17-20, 22,23 | |
| Y | * abstract; figure 1 * | 6,7,19, 20,22,23 | |
| X | DE 32 30 772 A (BOSCH GMBH ROBERT) 23 February 1984 (1984-02-23) | 1-3,10, 12-15, 17,22,23 | |
| | * abstract; figure 1 * | | |
| X | US 5 146 186 A (VELLA PAUL L) 8 September 1992 (1992-09-08) | 1,4-6, 10,12, 22,23 | |
| | * column 6, line 28 - line 49; figure 8 * | | TECHNICAL FIELDS SEARCHED (Int.Cl.7) |
| | | | H03L |

The present search report has been drawn up for all claims

| Place of search | Date of completion of the search | Examiner |
|---|---|---|
| Munich | 21 October 2004 | Boudet, J |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

   ...........................................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 04 01 8296

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2004

| Patent document cited in search report | | Publication date | Patent family member(s) | | Publication date |
|---|---|---|---|---|---|
| US 6417703 | B1 | 09-07-2002 | NONE | | |
| US 5128633 | A | 07-07-1992 | EP | 0593642 A1 | 27-04-1994 |
| | | | JP | 6509217 T | 13-10-1994 |
| | | | WO | 9301657 A1 | 21-01-1993 |
| DE 3230772 | A | 23-02-1984 | DE | 3230772 A1 | 23-02-1984 |
| US 5146186 | A | 08-09-1992 | NONE | | |

EPO FORM P0459

For more details about this annex : see Official Journal of the European Patent Office, No. 12/82